# EUROPEAN PATENT APPLICATION

(11) **EP 1 940 211 A2**
(43) Date of publication of application: **02.07.2008**
(21) Application number: 07024007.2
(22) Date of filing: 11.12.2007
(51) Int. Cl.: H05K 7/14, H05K 7/20

(54) **Plug-in unit and electronic apparatus**

(30) Priority: 27.12.2006 JP 2006352088
(71) Applicant: NEC Corporation, Minato-ku Tokyo (JP)
(72) Inventor: Hattori, Takeshi, Minato-ku, Tokyo (JP)
(74) Representative: Glawe, Delfs, Moll

(57) **Abstract**

A plug-in unit in which a flow rate of cooling air to be supplied thereto or to be sucked therefrom is adjustable; and an electronic apparatus in which, even if an existing plug-in unit is replaced by a plug-in unit which is different in a caloric value and a ventilation resistance from the existing plug-in unit, a flow rate distribution can be appropriately changed. In the plug-in unit to be accommodated for use in a housing of an electronic apparatus with a cooling fan, there is arranged a flow rate adjusting member which includes an opening with a variable opening ratio for adjusting a flow rate of air in at least a section thereof as an inlet of cooling air generated by the cooling fan or a section thereof as an outlet of the cooling air when the plug-in unit is accommodated in the housing of the electronic apparatus.

## Description

This application is based upon and claims the benefit of priority from Japanese patent application No. 2006-352088, filed on December 27, 2006, the disclosure of which is incorporated herein its entirety by reference.

### BACKGROUND OF THE INVENTION

### Field of the Invention

The present invention pertains to a plug-in unit including an electronic device and an electronic apparatus including a back plug-in structure and a plurality of mounting slots, and in particular, to an electronic apparatus in which even an existing plug-in unit beforehand installed therein is replaced by a plug-in unit which is different in a caloric value and a ventilation resistance from the existing plug-in unit, an appropriate flow rate of air can be adjusted without changing a housing configuration of the electronic apparatus.

### Description of the Related Art

In an electronic apparatus in which heat dissipated from plug-in units are forcibly cooled by air using a cooling fan, if the air flow rate of the air is restricted to optimize noise and power of the fan, the distribution of the flow rate of the cooling air flow is optimally adjusted in the apparatus according to the caloric value of each plug-in unit and the ventilation resistance in a path of an air flow.

Japanese Patent Laid-Open Pub. Ser. Nos. 2004-146631 and 2004-152896 describe structures to adjust the flow rate of the cooling air flow in such electronic apparatus. The structure includes a flow rate adjusting plate disposed in a location of an intake hole or an exhaust hole of the plug-in unit.

The flow rate adjusting plate includes a porous plate of which an opening ratio varies for each plug-in unit and is fixedly attached on a housing side.

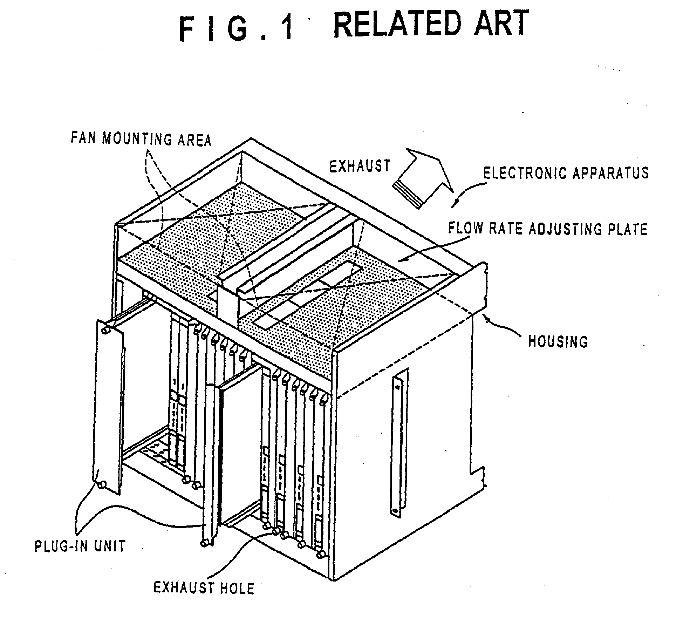

As FIG. 1 shows, according to the electronic apparatus with a flow rate adjusting function in accordance with Japanese Patent Application Laid-Open Ser. Nos. 2004-146631 and 2004-152896, the flow rate adjusting plate is fixed onto a housing of the apparatus. Therefore, when it is desired to replace an existing plug-in unit by a plug-in unit which is different in the caloric value and the ventilation resistance from the existing plug-in unit, the opening ratio of the plate cannot be changed even if the plug-in units are compatible with each other. This disadvantageously makes it difficult to keep the appropriate flow rate distribution depending on cases.

Japanese Patent Application Laid-Open Ser. No. 2004-63755 describes a rack cooling construction including a rack to accommodate an electronic apparatus. The rack includes openings of which the opening ratio is adjustable.

However, if this configuration is adopted for an electronic apparatus in the back plug-in structure, it is difficult to adjust the opening ratio of the openings of the rack. Particularly, in a situation wherein the apparatus having a small thickness and a large depth, a plug-in unit adjacent to the rack is required to be removed to adjust the opening ratio of the rack. This disadvantageously reduces efficiency of the operation to adjust the flow rate distribution.

Japanese Patent Application Laid-Open Ser. No. 2004-203013 describes a printer including a plurality of print units. Each print unit includes a shutter plate disposed for an intake hole formed in a housing of the print unit. If the temperature of the print unit exceeds a predetermined temperature, the intake hole is opened to take in external air. According to this technique, the opening ratio of the intake hole is step-wise adjusted according to the temperature of the print unit.

However, the configuration described in Japanese Patent Application Laid-Open Ser. No. 2004-203013 essentially requires such as sensors to detect the temperature of the print units and a mechanism to drive the shutter plate according to the detected temperature.

In general electronic apparatuses, unlike the printer, the caloric or heat value of each plug-in unit is almost equal to a predetermined value and which seldom changes during the operation of the unit. Therefore, even if such as the sensors and the mechanisms for the shutter are disposed as described in Japanese Patent Application Laid-Open Ser. No. 2004-203013, it is not effective for the adjustment of the flow rate distribution, but the apparatus increases in size and the configuration thereof becomes complicated.

### SUMMARY OF THE INVENTION

An exemplary object of the invention is to provide an electronic apparatus being characterized in that even if an existing plug-in unit is replaced by another plug-in unit that is capable of adjusting a flow rate of cooling air when installed in the electronic apparatus or by a plug-in unit that has a different caloric value and a ventilation resistance from the existing plug-in unit, the flow rate distribution can be appropriately altered in the apparatus.

A plug-in unit according to an exemplary aspect of the present invention to be accommodated for use in a housing of an electronic apparatus with a cooling fan includes a flow rate adjusting member that includes an opening with a variable opening ratio for adjusting a flow rate of air in at least a section thereof as an inlet of cooling air generated by the cooling fan or a section thereof as an outlet of the cooling air when the plug-in unit is accommodated in the housing of the electronic apparatus.

An electronic apparatus according to an exemplary aspect of the invention includes a plurality of mounting slots to accommodate in a housing a plug-in unit in either one of the configuration.

### BRIEF DESCRIPTION OF THE DRAWINGS

The objects and features of the present invention will become more apparent from the consideration of the following detailed description taken in conjunction with the accompanying drawings in which:
FIG. 1 is a schematic block diagram showing the flow rate adjusting structure in a conventional electronic apparatus;
FIG. 2 is a perspective view showing a configuration of an electronic apparatus of an embodiment in accordance with the present invention;
FIG. 3 is a cross-sectional view showing a configuration of an electronic apparatus of an embodiment in accordance with the present invention;
FIGS. 4A to 4C are diagrams showing an example of a plug-in unit; and
FIGS. 5A to 5C are diagrams showing another example of a plug-in unit.

### DESCRIPTION OF EXEMPLARY EMBODIMENTS

### First Exemplary Embodiment

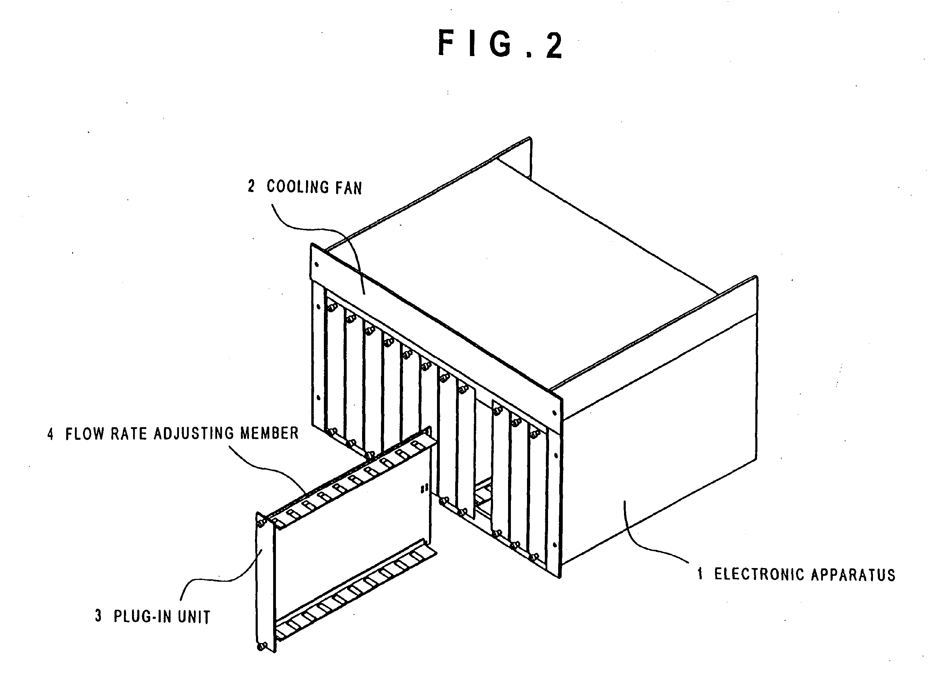

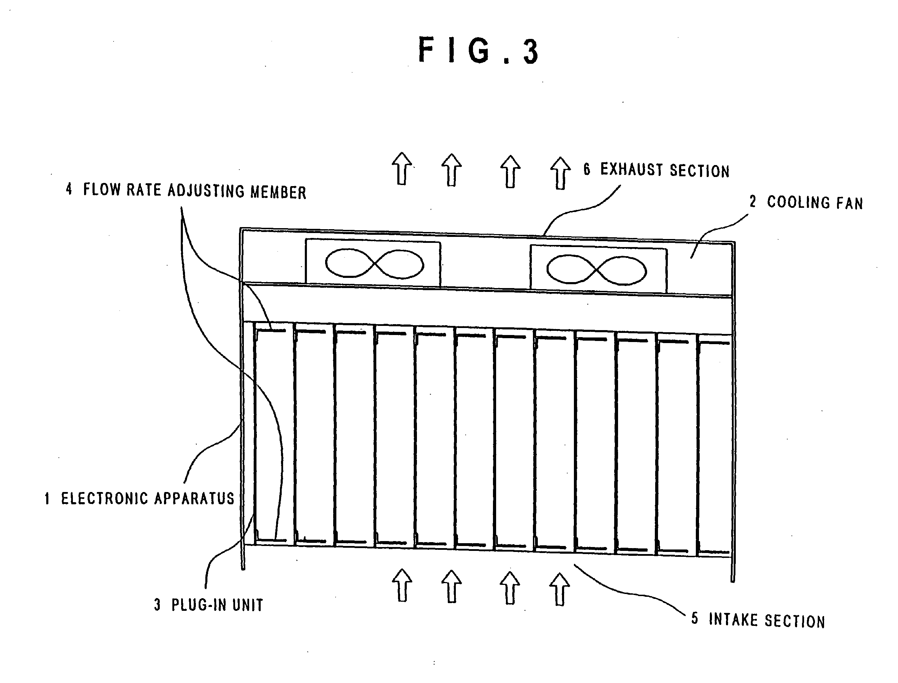

Description will be given of an exemplary embodiment in accordance with the present invention. FIGS. 2 and 3 show a construction of an electronic apparatus 1. In an electronic apparatus 1 that includes a back plug-in structure, a plurality of plug-in units 3 is mounted. The electronic apparatus 1 includes a cooling fan 2 to forcibly cool heat generated by the plug-in units 3. The electronic apparatus 1 also includes an intake section 5 in a lower section thereof and an exhaust section 6 in an upper section thereof.

In the cooling fan 2, a flow rate of air thereof is adjustable by controlling the number of rotations of the fan according to temperature of exhaust detected.

The plug-in unit 3 includes flow rate adjusting members 4 which are porous plates with different opening ratios individually.

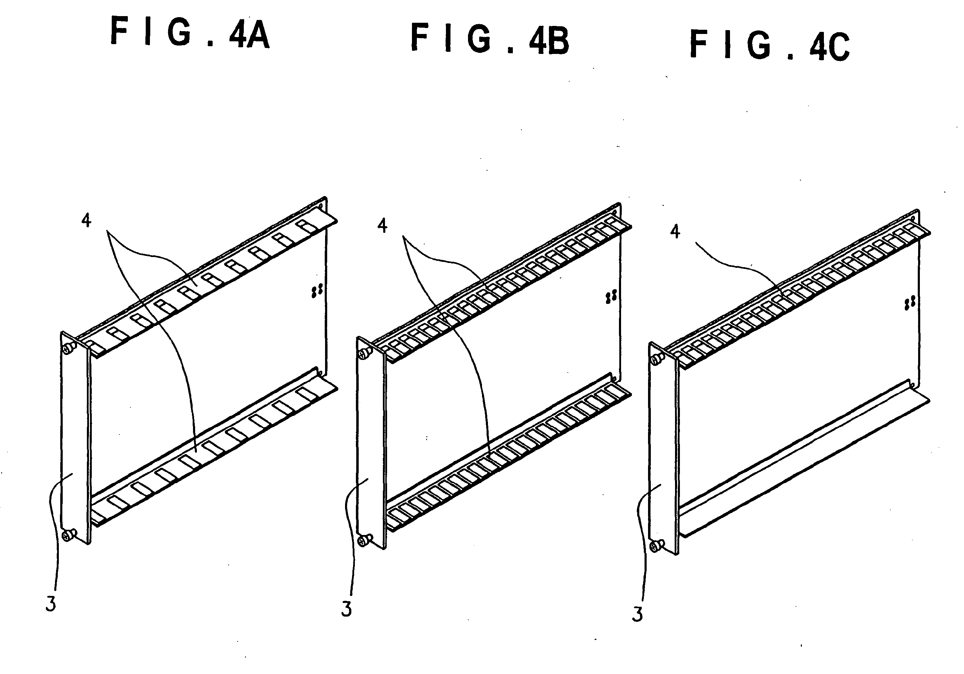

FIGS. 4A to 4C show a configuration of the plug-in unit 3. In the plug-in unit 3, the flow rate adjusting member 4 includes a configuration with the variable opening. It is possible to employ a configuration in which a sliding plate is disposed at the opening to change the opening ratio of holes or a configuration in which a removable lid is arranged at the opening. The configuration to achieve the variable opening ratio in the flow rate adjusting member 4 is not restricted by the above examples, but other configurations are also applicable to achieve the purpose.

As FIG. 4A shows, for the plug-in unit 3 with a smaller caloric value, the opening ratio may be adjusted at a low level by the flow rate adjusting member 4. If a plug-in unit 3 has a larger caloric value, the opening ratio may be adjusted at a high level by the flow rate adjusting member 4 as shown in FIG. 4B. Additionally, as can be seen from FIG. 4C, the opening may be closed by the flow rate adjusting member 4 for a plug-in unit 3 with quite a small caloric value.

The lower the opening ratio of the flow rate adjusting member 4 of a particular plug-in unit 3 is, the more the flow rate of the cooling air supplied to the other plug-in units 3 is. Contrarily, the higher the opening ratio of the flow rate adjusting member 4 of the particular plug-in unit 3 is, the less the flow rate of the cooling air supplied to the other plug-in units 3 is. Therefore, by adjusting the opening ratio of the flow rate adjusting member 4 of each plug-in unit 3, it is possible to distribute the cooling air at a desired ratio to each of the plug-in units 3.

Even if an existing plug-in unit 3 beforehand installed in the electronic apparatus is replaced by a plug-in unit 3 which is different in the caloric value from the existing plug-in unit, since the new plug-in unit 3 includes the flow rate adjusting member 4 to adjust the flow rate according to the caloric value, it is possible to appropriately control the opening ratio in association with the new plug-in unit 3.

Since the opening ratio is adjustable in a state wherein the plug-in unit 3 is removed from the electronic apparatus 1, there is obtained appropriate operability in the adjusting job.

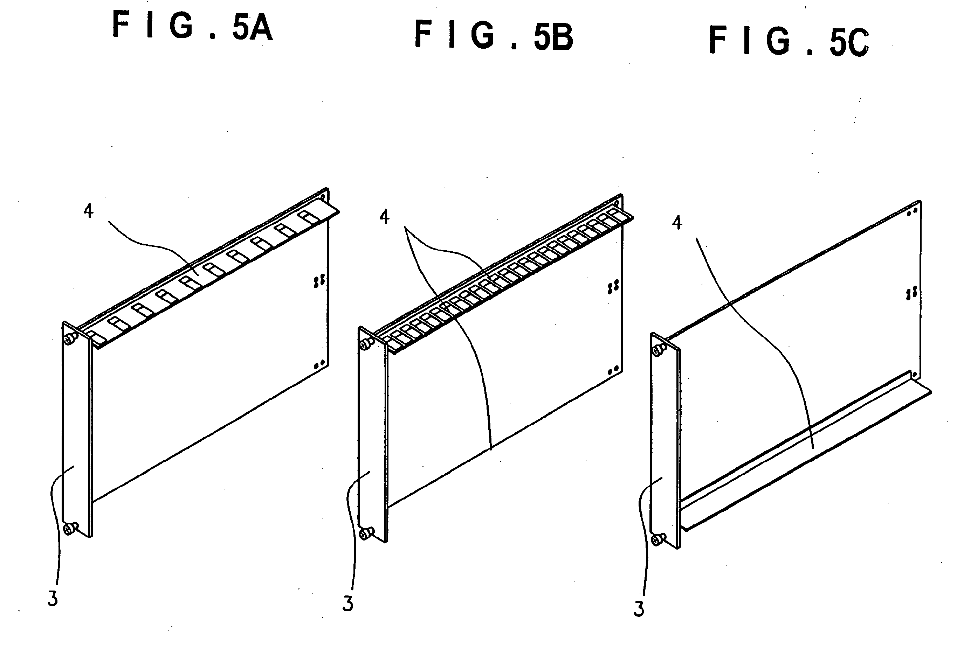

FIGS. 5A to 5C show another example of the configuration of the plug-in unit 3. In the configuration, the flow rate adjusting member 4 is arranged only on one side edge of the plug-in unit 3. However, even if the flow rate adjusting member 4 is disposed on one side edge, an advantageous function similar to that of the configuration shown in FIG. 3 is achieved.

By adjusting the flow rate distribution for each of the plug-in units, it is possible to uniformly set the exhaust air temperature of each plug-in unit.

If the exhaust air temperature varies between the plug-in units, a lifetime of the plug-in unit the highest exhaust air temperature among the plug-in units corresponds to a lifetime of the apparatus. However, if the exhaust air temperature is achieved to be uniformly controlled, the highest temperature of the plug-in unit can be lowered as much as possible. This advantageously elongates the lifetime of the device.

As above, in the electronic apparatus in accordance with the present invention, even if an existing plug-in unit is replaced by a plug-in unit which is different in the caloric value and the ventilation resistance from the existing plug-in unit, it is possible to appropriately control the flow rate distribution without changing the housing structure of the apparatus.

Since the flow rate distribution is adjustable by the structure (including the flow rate adjusting member) on the plug-in unit side, the housing of the electronic apparatus can be shared irrespectively of the configuration and the kind of the plug-in unit. This leads to an advantage of cost reduction.

### Second Exemplary Embodiment

The opening ratio of the flow rate adjusting member may be variable within a range according to a caloric value of an electronic device mounted in the apparatus.

### Third Exemplary Embodiment

The flow rate adjusting member may be capable of adjusting the opening ratio by sliding a sliding member arranged near the opening. Alternatively, it is desirable that the flow rate adjusting member is capable of adjusting the opening ratio by attaching or removing a lid disposed to close the opening.

### Fourth Exemplary Embodiment

It is favorable for the electronic apparatus that the cooling fan produces a flow of cooling air by forcibly sucking air from the plug-in unit mounted in the mounting slot. Or, it is desirable that the cooling fan produces a flow of cooling air by forcibly supplying air to the plug-in unit mounted in the mounting slot.

The exemplary embodiments have been described only as examples of the present invention, but the present invention is not restricted by the exemplary embodiments.

For example, in the description of the exemplary embodiments, the cooling fan is disposed on the exhaust side to forcibly suck air from the housing in the configuration of each embodiment. However, even if the cooling fan is arranged on the intake side to forcibly feed air into the housing, there is obtained an advantage similar to that of the above configuration.

As described above, in accordance with the present invention, the embodiments can be changed and modified in various ways.

While the present invention has been described with reference to the particular illustrative embodiments, it is not to be restricted by those embodiments but only by the appended claims. It is to be appreciated that those skilled in the art can change or modify the embodiments without departing from the scope and spirit of the present invention.

## Claims

1. A plug-in unit to be accommodated for use in a housing of an electronic apparatus with a cooling fan, comprising a flow rate adjusting member which includes an opening with a variable opening ratio for adjusting a flow rate of air in at least a section thereof as an inlet of cooling air generated by the cooling fan or a section thereof as an outlet of the cooling air when the unit is accommodated in the housing of the electronic apparatus.

2. The plug-in unit in accordance with claim 1, wherein the opening ratio of the flow rate adjusting member is variable in a range corresponding to a caloric value of an electronic device mounted in the apparatus.

3. The plug-in unit in accordance with claim 1 or 2, wherein the flow rate adjusting member is capable of adjusting the opening ratio by sliding a sliding member arranged near the opening.

4. The plug-in unit in accordance with claim 1 or 2, wherein the flow rate adjusting member is capable of adjusting the opening ratio by attaching or removing a lid disposed to close the opening.

5. An electronic apparatus, comprising a plurality of mounting slots to accommodate in the housing a plug-in unit in accordance with one of claims 1 to 4.

6. The electronic apparatus in accordance with claim 5, wherein the cooling fan generates the cooling air by forcibly sucking air from the plug-in unit mounted in the mounting slot.

7. The electronic apparatus in accordance with claim 5, wherein the cooling fan generates the cooling air by forcibly supplying air into the plug in unit mounted in the mounting slot.
